# EUROPÄISCHE PATENTSCHRIFT

(11) **EP 2 167 809 B1**
(45) Veröffentlichungstag und Bekanntmachung des Hinweises auf die Patenterteilung: **12.01.2011**
(21) Anmeldenummer: 08760166.2
(22) Anmeldetag: 29.05.2008
(51) Int. Cl.: F02M 51/00, F02M 63/00, H01L 41/053

(54) **PIEZOAKTORMODUL MIT KABELDURCHFÜHRUNGEN UND EIN VERFAHREN ZU DESSEN HERSTELLUNG**
PIEZO ACTUATOR MODULE HAVING CABLE BUSHINGS, AND METHOD FOR THE PRODUCTION THEREOF
MODULE À ACTIONNEUR PIEZO-ÉLECTRIQUE PRÉSENTANT DES PASSAGES DE CÂBLES, ET SON PROCÉDÉ DE RÉALISATION

(30) Priorität: 15.06.2007 DE 102007027665
(43) Veröffentlichungstag der Anmeldung: 31.03.2010
(73) Patentinhaber: Robert Bosch GmbH, 70442 Stuttgart (DE)
(72) Erfinder: PREIBISCH, Joerg, 96215 Lichtenfels (DE); LEISER, Stefan, 70176 Stuttgart (DE); STIEBER, Marco, 71254 Ditzingen (DE); LEISTER, Jens, 70806 Kornwestheim (DE); GRUBE, Caroline, 71732 Tamm (DE); WACHTER, Philipp, 70376 Bad Cannstatt (DE)
(86) Internationale Anmeldenummer: PCT/EP2008/056574
(87) Internationale Veröffentlichungsnummer: WO 2008/151939

(56) Entgegenhaltungen:
- EP-A- 1 630 408
- EP-A- 1 696 497
- WO-A-01/24321
- WO-A-2006/089818
- WO-A-2007/023047
- WO-A-2007/118726
- JP-A- 2006 307 796

## Beschreibung

### Stand der Technik

Die Erfindung betrifft ein Piezoaktormodul mit Kabeldurchführungen für einen Piezoaktor und ein Verfahren zu dessen Herstellung für die elektrische Kontaktierung des Piezoaktors im Piezoaktormodul gemäß der Gattung des Hauptanspruchs.

Ein solches Piezoaktormodul kann beispielsweise als Piezoinjektor zur zeitpunkt- und mengengenauen Dosierung von Kraftstoff in einem Verbrennungsmotor eingesetzt werden und besteht im Wesentlichen aus einem Haltekörper und dem im Haltekörper angeordneten, an sich bekannten Piezoaktor, der zwischen einem Aktorkopf und einem Aktorfuß angeordnete, übereinandergestapelte Piezoelemente aufweist, die jeweils aus mit Innenelektroden eingefassten Piezolagen bestehen. Die Piezoelemente sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist bei einem Piezoinjektor mit einer Düsennadel verbunden, sodass durch Anlegen einer elektrischen Spannung an die Piezoelemente eine Düsenöffnung freigegeben oder geschlossen wird.

Aus der DE 101 39 871 A1 ist ein solcher Piezoinjektor mit einem über einen hydraulischen Druckübersetzer auf ein Ventilglied einwirkenden Piezoaktormodul bekannt, bei dem die Piezoelemente des Piezoaktors in einer Hülsen-Membran-Kombination angeordnet sind. An einem Ende befindet sich ein Stahlbauteil (Aktorfuß), durch das über isolierte Zuleitungen die elektrische Kontaktierung der Piezoelemente des Piezoaktors ermöglicht wird.

WO 2006 089 818 offenbart einen Aktorfuss mit darin eingebetteten Leitern. Der Aktorfuß besteht aus Verbundmaterial aus isolierend beschichteten Metallpartikeln.

Eine hier notwendige hochdruckdichte Einbettung der elektrischen Zuleitungen in das Piezoaktormodul, insbesondere in den Aktorfuß, ist beispielsweise in der DE 10 2004 004 706 A1 beschrieben. Hier wird unter anderem eine Einbettung der Kabel der Zuleitung mittels einer Glaseinschmelzung, beispielsweise auch in einem Keramikbauteil als Aktorfuß, vorgeschlagen. Der Aktorfuß als Keramikbauteil stützt sich bei dieser bekannten Anordnung über kegelstumpfförmige Anlageflächen unter einer mechanischen Vorspannung im Haltekörper eines Piezoinjektors ab.

Hierbei muss beachetet werden, dass ein glaseingeschmolzene Abdichtung, zum Beispiel gegen Drücke von ca. 2000 bar, im Aktorfuß des Piezoaktormoduls erfolgen muss. Die zuvor erwähnte Glaseinschmelzung wird entweder als separates Bauteil in ein Trägerbauteil aus Metall eingepresst oder das Glas wird direkt in das Metallteil eingeschmolzen. Nachteilig ist diese Anordnung vor allem deshalb, weil die Pressverbindung eventuell nicht vollständig dicht gemacht werden kann und eine Kontaktierung eventuell sehr aufwändig ist.

### Offenbarung der Erfindung

Die Erfindung geht von einem eingangs beschriebenen Piezoaktormodul mit Kabeldurchführungen für einen Piezoaktor aus, der zwischen einem Aktorkopf und einem Aktorfuß angeordnete Piezoelemente aufweist. Hierbei sind im keramischen Aktorfuß isoliert verlaufende Leitungen für die elektrische Kontaktierung der Piezoelemente über Außenelektroden vorhanden. Erfindungsgemäß sind in vorteilhafter Weise in den keramischen Aktorfuß elektrisch leitende Einlagen als Leiter im Aktorfuß miteingesintert, die an Kontaktstellen zu den Piezoelementen mit den Außenelektroden und am anderen Ende über Kontaktstellen mit Zuleitungen für die elektrische Ansteuerung des Piezoaktromoduls verbunden werden.

Weiterhin kann der Aktorfuß aus Keramik in vorteilhafter Weise mit einer kegelstumpfförmigen Anlagefläche an eine korrespondierende Anlagefläche in einem Haltekörper als Gehäuse dichtend angefügt und abgestützt werden und dann können an die eingesinterten leitenden Einlagen die äußeren Zuleitungen angefügt werden. Mit einer entsprechenden mechanischen Vorspannung des Piezoaktors kann dann die notwendige Dichtkraft für den Kegel mit dem Aktrofuß aufgebracht werden, die notwendig ist, um den Raum mit dem Piezoaktor nach außen abzudichten. Die leitenden Einlagen können auf einfache Weise durch Drähte gebildet werden, die über Löt- oder Schweißverbindungen an die Außenelektroden und/oder die Zuleitungen anfügbar sind.

Vorzugsweise kann das Einbringen der elektrisch leitenden Einlagen während eines Sinterverfahrens für den Aktorfuß und/oder den Piezoaktor erfolgen. Daran anschließend kann eine Verklebung mit anderen Bauelelmenten durchgeführt werden.

Bei einem bevorzugten Anwendungsbeispiel ist ein Piezoaktormodul mit den zuvor erwähnten Kabeldurchführungen Bestandteil eines Piezoinjektors für ein Einspritzsystem für Kraftstoff bei einem Verbrennungsmotor, bei dem sich im Raum mit dem Piezoaktor der einzuspritzende Kraftstoff befindet. Der Aktorfuß aus Keramik und der Piezoaktor werden dabei zum Beispiel durch Kleben miteinander verbunden.

### Kurze Beschreibung der Zeichnungen

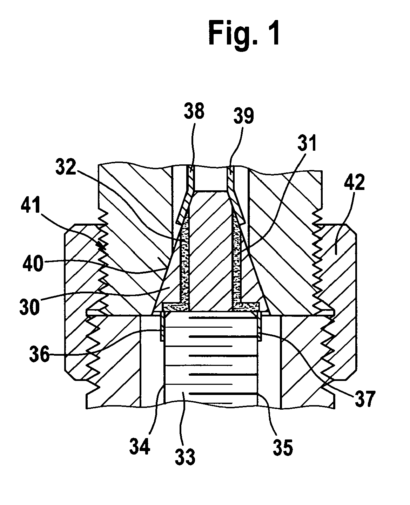

Die Erfindung wird nachfolgend anhand eines in der Zeichnung gezeigten Ausführungsbeispiels in einer einzigen Figur 1 erläutert, die eine separate Darstellung des Aktorfußes des erfindungsgemäßen Piezoaktormoduls mit eingesinterten Leitern in einem keramischen Aktorfuß als Kabeldurchführungen zeigt.

### Ausführungsform der Erfindung

Figur 1 zeigt erfindungswesentliche Bereiche eines Piezoaktormoduls mit einem Aktorfuß 30. Ein solches Piezoaktormodul ist aus dem in der Beschreibungseinleitung gewürdigten Stand der Technik bereits bekannt und kann beispielsweise, wie dort beschrieben, zur Nadelhubsteuerung im Einspritzsystem für Kraftstoff bei einem Verbrennungsmotor eingesetzt werden.

In der Figur 1 sind erfindungsgemäße Kabeldurchführungen in dem Aktorfuß 30 gezeigt, die hier als eingesinterte Leiter 31 und 32 eingefügt sind. Ein Piezoaktor 33 ist hier schematisch gezeigt und mit seinen Außenelektroden 34 und 35 mittels Kontaktstellen 36 und 37 mit den Leitern 31 und 32 verbunden, zum Beispiel durch Löten.

Am anderen Ende der Leiter 31 und 32 sind Zuleitungen 38 und 39 angefügt, mit denen die äußere Kontaktierung des erfindungsgemäßen Piezoaktormoduls hergestellt werden kann. Der Aktorfuß 30 ist über eine kegelstumpfförmige Anlagefläche 40 an Bauteilen eines Haltekörpers 41 selbstverstärkend dichtend angedrückt bzw. abgestützt, wobei hier zwei Gehäuseteile des Haltekörpers 41 mittels einer Mutter 42 in an sich bekannter Weise zusammengeschraubt sind. Hiermit kann gewährleistet werden, dass eine hohe mechanische Vorspannung auf den Piezoaktor 33 wirkt, da die notwendige Dichtkraft über die kegelstumpfförmige Anlagefläche 40 leicht aufgebracht werden kann.

## Patentansprüche

1. Piezoaktormodul mit Kabeldurchführungen für einen Piezoaktor (33), der zwischen einem Aktorkopf und einem Aktorfuß (30) angeordnete Piezoelemente aufweist und mit im Aktorfuß (30) isoliert verlaufenden Kabeln und Zuleitungen (38,39) für die elektrische Kontaktierung der Piezoelemente über Außenelektroden versehen ist, **dadurch gekennzeichnet, dass** in einem keramischen Aktorfuß (30) elektrisch leitende Einlagen als Leiter (31,32) im Aktorfuß (30) elektrisch isoliert miteingesintert sind, die an Kontaktstellen (36,37) zu den Piezoelementen mit den Außenelektroden (34,35) und über weitere Kontaktstellen mit den Zuleitungen (38,39) für das Piezoaktromodul elektrisch verbunden sind.

2. Piezoaktormodul nach Anspruch 1, **dadurch gekennzeichnet, dass** der Aktorfuß (30) mit einer kegelstumpfförmigen Anlagefläche (40) an eine korrespondierende Anlagefläche in einem Haltekörper (41) dichtend angefügt und abgestützt ist.

3. Piezoaktormodul nach Anspruch 1 oder 2, **dadurch gekennzeichnet, dass** die Leiter (31,32) Drähte sind, die über Löt- oder Schweißverbindungen an die Außenelektroden (34,35) und/oder die Zuleitungen (38,39) angefügt sind.

4. Verfahren zur Herstellung eines Piezoaktormoduls nach einem der vorhergehenden Ansprüche, **dadurch gekennzeichnet, dass** während eines Sinterverfahrens für den Aktorfuß (30) und/ oder den Piezoaktor (33) die leitenden Einlagen als Leiter (31,32) miteingesintert werden.

5. Piezoaktormodul, hergestellt mit einer Kabeldurchführung nach einem der vorhergehenden Ansprüche, **dadurch gekennzeichnet, dass** das Piezoaktormodul Bestandteil eines Piezoinjektors für ein Einspritzsystem für Kraftstoff bei einem Verbrennungsmotor ist.

## Claims

1. Piezo-actuator module having cable bushings for a piezo-actuator (33) which has piezo-elements arranged between an actuator head and an actuator base (30) and is provided with cables and feed lines (38, 39), running in insulated fashion in the actuator base (30), for forming electrical contact with the piezo-elements via external electrodes, **characterized in that**, in a ceramic actuator base (30), electrically conductive inlays are also sintered in in an electrically insulated fashion as conductors (31, 32) in the actuator base (30), which inlays are electrically connected to contact points (36, 37) between the piezo-elements and the external electrodes (34, 35), and via further contact points with the feed lines (38, 39) for the piezo-actuator module.

2. Piezo-actuator module according to Claim 1, **characterized in that** the actuator base (30) is attached in a seal-forming fashion by a frustum-shaped bearing face (40) to a corresponding bearing face in a securing body (41), and is supported thereon.

3. Piezo-actuator module according to Claim 1 or 2, **characterized in that** the conductors (31, 32) are wires which are attached to the external electrodes (34, 35) and/or the feed lines (38, 39) via soldered connections or welded connections.

4. Method for producing a piezo-actuator module according to one of the preceding claims, **characterized in that** the conductive inlays are also sintered in as conductors (31, 32) during a sintering process for the actuator base (30) and/or the piezo-actuator (33).

5. Piezo-actuator module, produced with a cable bushing according to one of the preceding claims, **characterized in that** the piezo-actuator module is a component of a piezo-injector for an injection system for fuel in an internal combustion engine.

## Revendications

1. Module d'actionneur piézoélectrique comprenant des passages de câble pour un actionneur piézoélectrique (33), qui présente des éléments piézoélectriques disposés entre une tête d'actionneur et une base d'actionneur (30), et qui est pourvu de câbles et de conduites d'amenée (38, 39) s'étendant de manière isolée dans la base d'actionneur (30) pour le contact électrique des éléments piézoélectriques par le biais d'électrodes extérieures, **caractérisé en ce que** dans une base d'actionneur céramique (30), des inserts électriquement conducteurs en tant que conducteurs (31, 32) sont incorporés par frittage de manière isolée électriquement dans la base d'actionneur (30), lesquels sont connectés électriquement en des points de contact (36, 37) avec les éléments piézoélectriques aux électrodes extérieures (34, 35) et par le biais d'autres points de contact aux conduites d'amenée (38, 39) pour le module d'actionneur piézoélectrique.

2. Module d'actionneur piézoélectrique selon la revendication 1, **caractérisé en ce que** la base d'actionneur (30) est assemblée hermétiquement et supportée, par une surface d'appui (40) de forme tronconique, sur une surface d'appui correspondante dans un corps de retenue (41).

3. Module d'actionneur piézoélectrique selon la revendication 1 ou 2, **caractérisé en ce que** les conducteurs (31, 32) sont des câbles qui sont assemblés par le biais de connexions brasées ou soudées aux électrodes extérieures (34, 35) et/ou aux conduites d'amenée (38, 39).

4. Procédé pour fabriquer un module d'actionneur piézoélectrique selon l'une quelconque des revendications précédentes, **caractérisé en ce que** pendant un procédé de frittage pour la base d'actionneur (30) et/ou pour l'actionneur piézoélectrique (33), les inserts conducteurs sont frittés conjointement en tant que conducteurs (31, 32).

5. Module d'actionneur piézoélectrique, fabriqué avec un passage de câble selon l'une quelconque des revendications précédentes, **caractérisé en ce que** le module d'actionneur piézoélectrique fait partie d'un injecteur piézoélectrique pour un système d'injection de carburant dans un moteur à combustion interne.
